# EUROPÄISCHE PATENTSCHRIFT

(11) **EP 0 450 157 B1**
(45) Veröffentlichungstag und Bekanntmachung des Hinweises auf die Patenterteilung: **09.02.1994**
(21) Anmeldenummer: 90122556.5
(22) Anmeldetag: 26.11.1990
(51) Int. Cl.: H05K 7/20

(54) **Elektronisches Einschubteil zum Einschieben in den Rahmen eines Schaltschrankes**
Electronic drawer for inserting in a cabinet frame
Tiroir électronique à introduire dans la bâti d'une armoire

(30) Priorität: 22.03.1990 DE 4009289
(43) Veröffentlichungstag der Anmeldung: 09.10.1991
(73) Patentinhaber: SIEMENS AKTIENGESELLSCHAFT, 80333 München (DE)
(72) Erfinder: Latussek, Hans-Peter, Dipl.-Ing., W-8501 Feucht (DE); Decker, Konrad, W-8551 Röttenbach (DE)

(56) Entgegenhaltungen:
- DE-U- 8 911 408
- FR-A- 2 580 137
- US-A- 4 769 557
- US-A- 4 872 102

## Beschreibung

Die Erfindung betrifft ein elektronisches Einschubteil zum Einschieben in den Rahmen eines Schaltschrankes, das an mindestens einer Seite einen Kühlkörper mit Kühlrippen zum Abführen der Verlustwärme elektronischer Bauelemente und mindestens eine mit elektronischen Leistungsbauteilen bestückte Leiterplatte aufweist, die im wesentlichen parallel zum Kühlkörper angeordnet ist, wobei die elektronischen Leistungsbauteile auf der Leiterplatte im wesentlichen auf der dem Kühlkörper zugewandten Seite angebracht sind und die Kühlrippen bündig mit einer Ebene abschließen, die durch die maximal zulässige Breite des Einschubteils festgelegt ist.

Derartige Einschubteile sind, z.B. als 19"-Einschubteile, weit verbreitet. Sie können u.a. Steuerungen für Kraftwerksanlagen (auch Kernkraftwerke) oder andere Anlagen (z.B. Elektrofilter oder Werkzeugmaschinen) enthalten.

Das Problem dieser Einschubteile besteht darin, daß ihr Volumen aufgrund der vorgegebenen Außenabmessungen beschränkt ist.

Aufgabe der vorliegenden Erfindung ist es, diesen begrenzten Raum möglichst effektiv zu nutzen, also möglichst viele elektronische Elemente im Einschubteil unterzubringen und miteinander zu verschalten. Dabei soll ferner die Verschaltung so geschehen, daß ein fehlerhaftes Verschalten erschwert bzw. unmöglich gemacht wird.

Die Aufgabe wird dadurch gelöst, daß die Leiterplatte über flache, federnde Metallteile mit schaltbaren, auf dem Kühlkörper befestigten Leistungshalbleitern im wesentlichen niveaugleich mit den Leistungshalbleitern elektrisch leitend verbunden ist und die Innenseite des Kühlkörpers in ihrer Kontur dem Höhenverlauf der Bauteile der Leiterplatte und der schaltbaren Leistungshalbleiter angepaßt ist.

In einer vorteilhaften Ausgestaltung der Erfindung sind die Kühlrippen des Kühlkörpers so angeordnet, daß die Bohrungen zur Befestigung des Kühlkörpers am Einschubteil und der Bauteile der Leiterplatte und der schaltbaren Leistungshalbleiter am Kühlkörper in den Zwischenräumen zwischen den Kühlrippen liegen. Dies bringt fertigungstechnische Vorteile mit sich: Es ist kein Entgraten der Bohrungen mehr nötig, das sonst durchgeführt werden muß, um mögliche Kurzschlüsse durch herabfallende Metallspäne zu vermeiden.

In einer weiteren vorteilhaften Ausgestaltung der Erfindung weisen die der elektrischen Verbindung dienenden Metallteile schmale, bei Verbindung der Leistungshalbleiter mit der Leiterplatte durchzutrennende Stege auf, wodurch Verdrahtungsfehler bei der Montage nahezu unmöglich werden. Wenn die Verbindungsstege weiterhin in Löchern verlaufen, die zur Aufnahme von Befestigungselementen dienen, kann es praktisch nicht vorkommen, daß bei der Montage vergessen wird, die Verbindungsstege durchzutrennen.

Weitere Vorteile und Einzelheiten ergeben sich aus der nachfolgenden Beschreibung eines Ausführungsbeispiels, anhand der Zeichnungen und in Verbindung mit den weiteren Einzelansprüchen. Dabei zeigen die
- FIG 1: eine Draufsicht und Teilschnitt eines geöffneten, erfindungsgemäßen Einschubteils, und
- FIG 2: eine Detailansicht eines Metallteils zum Verbinden der Leistungshalbleiter mit der Leiterplatte.

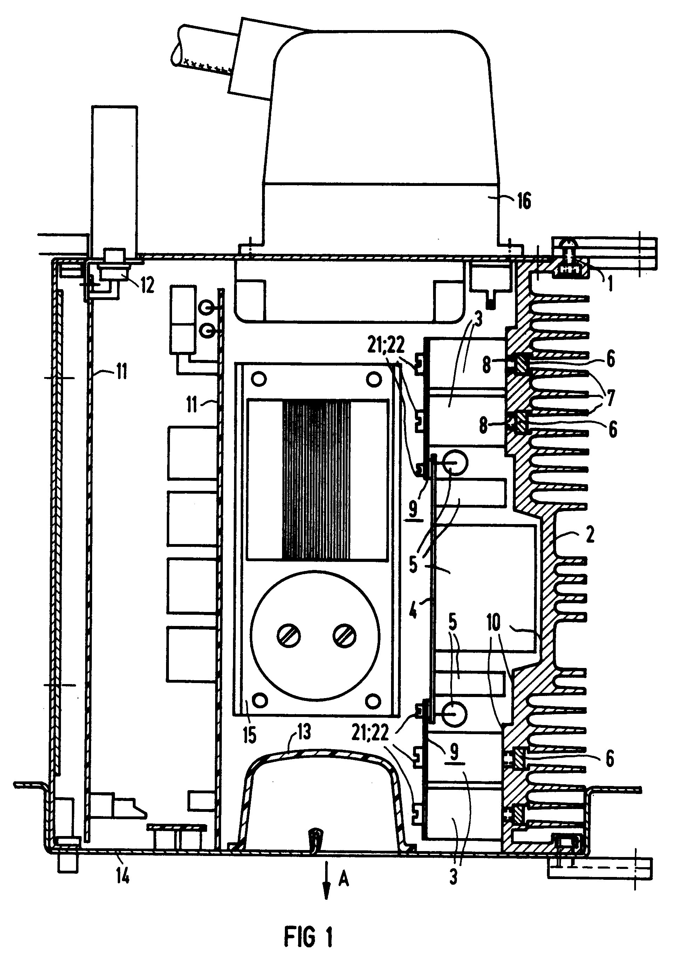

Wie FIG 1 zeigt, ist an einem Einschubteil auf einer Seite mittels Schrauben 1 ein Kühlkörper 2 befestigt, der zum Abführen der Verlustleistung dient, die von Thyristoren 3 (oder anderen schaltbaren Leistungshalbleitern wie z.B. GTO's) sowie von einer Leiterplatte 4, die mit elektronischen Leistungsbauteilen 5 bestückt ist, abgegeben wird. Die Thyristoren 3 sind mit Schrauben 6 am Kühlkörper 2 befestigt. Die Kühlrippen 7 des Kühlkörpers 2 sind dabei so angeordnet, daß die Löcher 8 für die Schrauben in den Lücken zwischen den Kühlrippen 7 liegen. Mit Schrauben 21, 22 an den Thyristoren 3 und an der Leiterplatte 4 befestigte Metallteile 9 stellen die elektrische Verbindung zwischen den Thyristoren 3 und der Leiterplatte 4 her. Da die Metallteile 9 federnd ausgestaltet sind, wird die Leiterplatte 4 automatisch niveaugleich zu den Thyristoren 3 und parallel zum Kühlkörper 2 ausgerichtet.

Fertigungstechnisch bedeutet der angepaßte Abstand der Kühlrippen 7 voneinander nahezu keinen Mehraufwand, vorteilhaft wird dagegen der Aufwand für das Entgraten der für die Schrauben 1, 6 zu bohrenden Löcher 8, das nötig ist, um Sicherzustellen, daß keine Bohrspäne später auf weiter unten im Schaltschrank angeordnete Teile fallen und dort Kurzschlüsse verursachen, stark reduziert.

Die Leistungsbauteile 5 der Leiterplatte 4 sind zumindest großteils dem Kühlkörper 2 zugewandt. Die Kontur 10 des Kühlkörpers 2 ist dabei dem Höhenverlauf der Bauteile 5 auf der Leiterplatte 4 möglichst optimal angepaßt. Hierdurch wird das Abführen größerer Wärmemengen ermöglicht. Die Länge der Kühlrippen 7 ist dabei so variiert, daß ihre Spitzen bündig mit einer Ebene abschließen, die durch die maximal zulässige Breite des Einschubteils festgelegt ist.

Auf der anderen Seite des Einschubteils sind beispielsweise die Logikplatinen 11 zur Steuerung und Regelung des Leistungsteils 3, 4, 5 angeordnet. Die externe Datenein- und/oder -ausgabe erfolgt hierbei über einen auf der Rückseite des Einschubteils angeordneten vielpoligen Stecker, z.B. einen Sub-D Stecker 12.

An der Vorderseite des Einschubteils ist in der Mitte eine elektrisch isolierte Griffmulde 13 angebracht, in die ein Teil der Frontabdeckung 14 hineinragt. An dieser Frontabdeckung 14 kann das Einschubteil in Richtung des Pfeiles A aus dem Rahmen des Schaltschranks herausgezogen werden. Hinter der Griffmulde 3, zwischen der Leiterplatte 4 für die elektronischen Leistungsbauteile 5 auf der einen Seite und den Logikplatinen 11 auf der anderen Seite, befindet sich die Stromversorgung 15 für den Leistungsteil 3, 4, 5. Die Stromversorgung 15 ist über einen an der Rückseite des Einschubteils befindlichen, mehrpoligen Leistungsstecker 16 an eine externe Stromversorgung sowie z.B. an zu steuernde Antriebe angeschlossen.

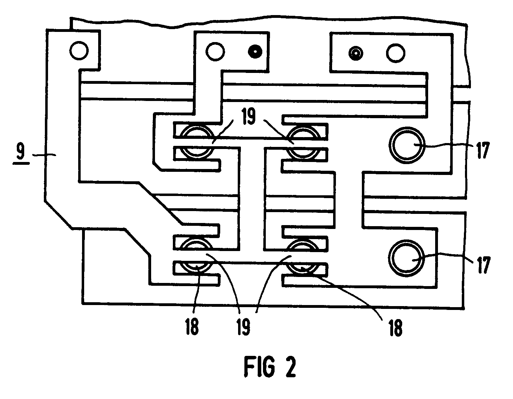

FIG 2 zeigt beispielhaft ein Metallteil 9 nach Anspruch 3 und 4. Im einfachsten Fall ist das Metallteil 9 durch Stanzen hergestellt. Es wird zunächst durch Schrauben 21 an den Stellen 17 mit den Thyristoren 3 und der Leiterplatte 4 verbunden. Wie aus FIG 2 ersichtlich ist, ist durch die Form des Metallteils 9 automatisch die Beschaltung von Thyristoren 3 und Leiterplatte 4 festgelegt. Ein falsches Verdrahten ist nicht mehr möglich. Die Verbindungsstege 19 müssen nach einem teilweisen Verdrahten durchgetrennt werden, um die restlichen Schrauben 22 in die Löcher 18 einsetzen zu können. Ein weiterer Vorteil der Metallteile 9 ist, daß mehrere aufeinander gelegt werden können, falls höhere Ströme zu übertragen sind. Ferner legt die elektrisch leitende Verbindung der Thyristoren 3 mit der Leiterplatte 4 durch die Metallteile 9 automatisch auch die Ausrichtung der Leiterplatte 4 parallel zum Kühlkörper 2 und niveaugleich mit den Thyristoren 3 fest. Da ferner die Metallteile 9, wie oben beschrieben, federnd ausgestaltet sind, sind größere Fertigungstoleranzen bei den Leistungsbauteilen 5 der Leiterplatte 4 und den Thyristoren 3 zulässig.

## Patentansprüche

1. Elektronisches Einschubteil zum Einschieben in den Rahmen eines Schaltschrankes,
- das an mindestens einer Seite einen Kühlkörper (2) mit Kühlrippen (7) zum Abführen der Verlustwärme elektronischer Bauelemente (3,5) und
- mindestens eine mit elektronischen Leistungsbauteilen (5) bestückte Leiterplatte (4) aufweist, die im wesentlichen parallel zum Kühlkörper angeordnet ist, wobei
- die elektronischen Leistungsbauteile (5) auf der Leiterplatte (4) im wesentlichen auf der dem Kühlkörper (2) zugewandten Seite angebracht sind und
- die Kühlrippen (7) bündig mit einer Ebene abschließen, die durch die maximal zulässige Breite des Einschubteils festgelegt ist,
**dadurch gekennzeichnet**, daß
- die Leiterplatte (4) über flache, federnde Metallteile (9) mit schaltbaren, auf dem Kühlkörper (2) befestigten Leistungshalbleitern (3) im wesentlichen niveaugleich mit den Leistungshalbleitern (3) elektrisch leitend verbunden ist und
- die Innenseite des Kühlkörpers (2) in ihrer Kontur (10) dem Höhenverlauf der Bauteile (5) der Leiterplatte (4) und der schaltbaren Leistungshalbleiter (3) angepaßt ist,

2. Einschubteil nach Anspruch 1, **dadurch gekennzeichnet,** daß die Kühlrippen (7) des Kühlkörpers (2) so angeordnet sind, daß die Bohrungen (8) zur Befestigung des Kühlkörpers (2) am Einschubteil und der Bauteile (5) der Leiterplatte (4) und der schaltbaren Leistungshalbleiter (3) am Kühlkörper (2) in den Zwischenräumen zwischen den Kühlrippen (7) liegen.

3. Einschubteil nach Anspruch 1 oder 2, **dadurch** **gekennzeichnet**, daß die Metallteile (9) schmale, bei Verbindung der Leistungshalbleiter (3) mit der Leiterplatte (4) durchzutrennende Verbindungsstege (19) aufweisen.

4. Einschubteil nach Anspruch 3, **dadurch** **gekennzeichnet**, daß die Verbindungsstege (19) in Löchern (18) verlaufen, die zur Aufnahme von Befestigungselementen wie z. B. Schrauben (22) dienen.

5. Einschubteil nach einem oder mehreren der obigen Ansprüche, **dadurch gekennzeichnet**, daß das Einschubteil an der Vorderseite eine elektrisch isolierte Griffmulde (13) aufweist, in die seitlich ein Teil einer Vorderseitenabdeckung (14) hineinragt.

6. Einschubteil nach einem oder mehreren der obigen Ansprüche, **dadurch gekennzeichnet**, daß
- das Einschubteil nur an einer Seite eine mit elektrischen Leistungsbauteilen (5) bestückte Leiterplatte (4) aufweist, deren Verlustwärme mit dem Kühlkörper abgeführt wird,
- auf der dem Kühlkörper (2) abgewandten Seite des Einschubteils mindestens eine weitere Leiterplatte (11) angeordnet ist, die die Steuer-und Auswertelogik für den Leistungsteil (3, 4, 5) beinhaltet, und
- von den Leiterplatten (4, 11), der Griffmulde (13) und den Wänden des Einschubteils ein im wesentlichen quaderförmiger Raum umschlossen ist, in dem die Stromversorgung (15) für das Einschubteil angeordnet ist.

## Claims

1. Electronic plug-in portion for plugging into the frame of a switch cabinet,
- which portion has, on at least one side, a cooling body (2) with cooling ribs (7) for dissipating the heat of electronic components (3, 5) and
- at least one printed-circuit board (4) which is fitted with electronic power components (5) and is arranged so as to be substantially parallel to the cooing body, wherein
- the electronic power components (5) are provided on the printed-circuit board (4) substantially on the side which faces the cooling body (2), and
- the cooling ribs (7) end so as to be flush with a plane which is fixed by the maximum permissible width of the plug-in portion, characterised in that
- the printed-circuit board (4) is connected in an electrically conductive manner, by way of planar, resilient metal portions (9), with switchable power semiconductors (3), which are secured on the cooling body (2), so as to be substantially level with the power semiconductors (3), and
- the contour (10) of the inside of the cooling body (2) is adapted to the course of height of the components (5) of the printed-circuit board (4) and the switchable power semiconductors (3).

2. Plug-in portion according to claim 1, characterised in that the cooling ribs (7) of the cooling body (2) are arranged in such a way that the bore holes (8) for the securement of the cooling body (2) on the plug-in portion and the securement of the components (5) of the printed-circuit board (4) and the switchable power semiconductors (3) on the cooling body (2) lie in the interspaces between the cooling ribs (7).

3. Plug-in portion according to claim 1 or 2, characterised in that the metal portions (9) have narrow connecting webs (19) which can be cut through when connecting the power semiconductors (3) to the printed-circuit board (4).

4. Plug-in portion according to claim 3, characterised in that the connecting webs (19) extend in holes (18) which are used to receive securing elements such as, for example, screws (22).

5. Plug-in portion according to one or several of the above claims, characterised in that the plug-in portion has, on the front side, an electrically insulated recessed grip (13) into which a portion of a front-side cover (14) laterally projects.

6. Plug-in portion according to one or several of the above claims, characterised in that
- the plug-in portion has, just on one side, a printed-circuit board (4) fitted with electrical power components (5), the heat of which is dissipated with the cooling body,
- arranged on the side of the plug-in portion remote from the cooling body (2) there is at least one further printed-circuit board (11) which contains the control and evaluating logic unit for the power portion (3, 4, 5), and
- the printed-circuit boards (4, 11), the recessed grip (13) and the walls of the plug-in portion enclose a substantially parallelepiped block-shaped space in which the current supply (15) for the plug-in portion is arranged.

## Revendications

1. Tiroir électronique destiné à être inséré dans le cadre d'une armoire de commande,
- qui comporte, sur au moins un côté, un corps de refroidissement (2) pourvu de nervures de refroidissement (7) servant à évacuer la chaleur dissipée de composants électroniques (3,5), et
- au moins une plaquette à circuits imprimés (4) équipée de modules électroniques de puissance (5) et qui est disposée sensiblement parallèlement au corps de refroidissement,
- les composants électroniques de puissance (5) situés sur la plaquette à circuits imprimés étant disposés essentiellement sur la face tournée vers le corps de refroidissement (2), et
- des nervures de refroidissement (7) se terminant de niveau avec un plan qui est déterminé par la largeur maximale admissible du tiroir,
caractérisé par le fait que
- la plaquette à circuits imprimés (4) est reliée d'une manière électriquement conductrice, par l'intermédiaire de pièces métalliques élastiques plates (9), à des semiconducteurs de puissance commutables (3), fixés sur le corps de refroidissement (2), essentiellement au même niveau que les semiconducteurs de puissance (3), et
- la face intérieure du corps de refroidissement (2) a un contour (10) adapté à l'allure en hauteur des composants (5) de la plaquette à circuits imprimés (4) et du semiconducteur de puissance commutable (3).

2. Tiroir suivant la revendication 1, caractérisé en ce que les nervures de refroidissement (7) du corps de refroidissement (2) sont disposées de telle sorte que les perçages (8) servant à fixer le corps de refroidissement (2) sur le tiroir et les composants (5) de la plaquette à circuits imprimés (4) et les semiconducteurs de puissance commutables (3) sont situés sur le corps de refroidissement (2) dans les espaces intercalaires présents entre les nervures de refroidissement (7).

3. Tiroir suivant la revendication 1 ou 2, caractérisé par le fait que les pièces métalliques (9) possèdent des barrettes de liaison étroites (19), qui peuvent être rompues lors de la liaison des semiconducteurs de puissance (3) avec la plaquette à circuits imprimés (4).

4. Tiroir suivant la revendication 3, caractérisé par le fait que les barrettes de liaison (19) s'étendent dans des trous (18), qui sont utilisés pour recevoir des éléments de fixation comme par exemple des vis (22).

5. Tiroir suivant l'une ou l'autre des revendications précédentes, caractérisé par le fait que le tiroir possède, sur la face avant, une cavité de préhension (13) isolée électriquement, dans laquelle s'engage latéralement une partie du revêtement (14) de la face avant.

6. Tiroir suivant une ou plusieurs des revendications précédentes, caractérisé par le fait que
- le tiroir possède, uniquement d'un côté, une plaquette à circuits imprimés (4) équipée de composants électriques de puissance (5) et dont la chaleur dissipée est évacuée au moyen du corps de refroidissement,
- sur le côté du tiroir situé à l'opposé du corps de refroidissement (2) est disposée au moins une autre plaquette à circuits imprimés (11), qui contient la logique de commande et d'évaluation pour la partie de puissance (3,4,5), et
- les plaquettes à circuits imprimés (4,11), la cavité de préhension (13) et les parois du tiroir entourent un espace sensiblement parallélépipédique, dans lequel est disposé l'alimentation en courant (15) pour le tiroir.
